# EUROPÄISCHE PATENTANMELDUNG

(11) **EP 4 091 870 A1**
(43) Veröffentlichungstag der Anmeldung: **23.11.2022**
(21) Anmeldenummer: 22173533.5
(22) Anmeldetag: 16.05.2022
(51) Int. Cl.: B60L 58/16, G01R 31/392

(54) **ERHALTUNG DER LEBENSDAUER VON KOMPONENTEN EINES SCHIENENFAHRZEUGS**

(30) Priorität: 20.05.2021 DE 102021205146
(71) Anmelder: Siemens Mobility GmbH, 81739 München (DE)
(72) Erfinder: Ruppert, Swen, 91096 Möhrendorf (DE)

(57) **Zusammenfassung**

Die Erfindung betrifft ein Verfahren zum Betreiben eines Fahrzeugs, bei dem Informationen über den Gesundheitszustand (Ist-SoH) einer Komponente des Fahrzeugs vorliegen. Dieser Gesundheitszustand (Ist-SoH) wird mit einem vorgegebenen Gesundheitszustand (Soll-SoH) verglichen. Abhängig vom Ergebnis des Vergleichs wird zumindest eine den Energieverbrauch beim Betreiben des Fahrzeugs erhöhende oder verringernde Maßnahme vorgenommen. Weiterhin betrifft die Erfindung hierzu korrespondierend eine Vorrichtung oder ein System zur Datenverarbeitung, ein Computerprogramm, einen computerlesbaren Datenträger, sowie ein Datenträgersignal.

## Beschreibung

Die Erfindung betrifft das Betreiben eines Fahrzeugs, bei dem der Gesundheitszustand einer Komponente des Fahrzeugs berücksichtigt wird.

Schienenfahrzeuge mit Energiespeichern in Form von Batterien sind üblicherweise Batteriehybrid-Fahrzeuge, d.h. sie können als elektrisches Fahrzeug unter Oberleitung fahren und dabei die Batterie aufladen und auf nicht elektrifizierten Strecken mit gesenktem Stromabnehmer aus der Batterie gespeist fahren. Während der Fahrt auf der nicht elektrifizierten Strecke kann die Batterie beim elektrischen Bremsen aufgeladen werden.

Es ist absehbar, dass Energiepreise steigen werden und daher der Energieverbrauch zukünftig eine größere Rolle spielen wird. Insbesondere bei batteriebetriebenen elektrischen Fahrzeugen spielt die Energieeffizienz wegen dem Gewicht und den Kosten des vorgehaltenen Energiespeichers eine besondere Rolle. Oft steht jedoch ein Energieverbrauch optimierter Betrieb des Fahrzeugs im Widerspruch zur Lebensdauer optimierten Systemauslegung, d.h. ein Energie optimiertes System erreicht meist schnell die maximale Lebensdauer der Komponenten.

Hinsichtlich der Lebensdauerbeanspruchung von Komponenten des Fahrzeugs stellt sich das Problem unterschiedlicher Anforderungen und Gegebenheiten:
Erstens führen unterschiedliche Streckenanforderungen, eine sich ändernde Beanspruchung des Fahrzeugs und schwankende Umweltbedingungen auf den Strecken zu variierenden und unvorhersehbaren Lebensdauern der Komponenten.

Zweitens existieren Linien, welche stark von anderen Linien in Bezug auf die Lebensdauerbeanspruchung der Komponenten der Fahrzeuge abweichen, z.B. durch häufig notwendige Anfahrvorgänge mit hoher Beladung oder hoher Zyklenbelastung des Energiespeichers. Um einheitliche Fahrzeuge innerhalb einer Flotte zu haben, müsste auf diese einzelnen anspruchsvollen Linien hin das Gesamtsystem ausgelegt sein, was negative Auswirkungen haben kann auf Kosten und Umweltverschmutzung, z.B. durch das Vorsehen von großen Batterien in jedem Fahrzeug und/oder durch den häufigen Austausch von Komponenten, und auch für den Energieverbrauch, z.B. durch energieintensives Fahren zur Schonung der Lebenszeit der Komponenten.

Der Erfindung liegt die Aufgabe zugrunde, ein Verfahren aufzuzeigen, welches eine Verlängerung der Lebensdauer von Komponenten eines Fahrzeugs, insbesondere eines Schienenfahrzeugs, ermöglicht.

Diese Aufgabe wird durch ein Verfahren mit den Merkmalen des Anspruchs 1 gelöst. Ferner sind Gegenstand der Erfindung eine entsprechende Vorrichtung oder ein System zur Datenverarbeitung, ein entsprechendes Computerprogramm, ein entsprechender computerlesbarer Datenträger, und ein entsprechendes Datenträgersignal. Vorteilhafte Ausgestaltungen und Weiterbildungen sind Gegenstand von Unteransprüchen.

Bei dem erfindungsgemäßen Verfahren liegen Informationen über den Gesundheitszustand einer Komponente des Fahrzeugs vor. Dieser Gesundheitszustand wird mit einem vorgegebenen Gesundheitszustand verglichen. In Abhängigkeit vom Ergebnis des Vergleichs wird zumindest eine den Energieverbrauch beim Betreiben des Fahrzeugs erhöhende oder verringernde Maßnahme vorgenommen.

Die Art der Ermittlung des Gesundheitszustands ist nicht Gegenstand der Erfindung. Vielmehr wird davon ausgegangen, dass der Gesundheitszustand der betrachteten Komponente bekannt ist. Hierbei handelt es sich um einen Ist-Zustand, d.h. der dem Verfahren zugrunde gelegte Gesundheitszustand sollte möglichst gut den tatsächlichen aktuellen Zustand repräsentieren.

Der vorgegebene Gesundheitszustand kann eine Soll-Vorgabe sein. D.h. durch den Vergleich wird ermittelt, ob die betrachtete Komponente hinsichtlich ihres Alterungsvorgangs schlechter oder besser als der Sollwert ist. Das Ergebnis des Vergleichs entscheidet - zumindest als eine zum Einsatz kommende Einflussgröße - über die Vornahme einer Maßnahme. Dies kann sich einerseits in der Auswahl der vorzunehmenden Maßnahme äußern, andererseits auch in dem Ausmaß der Vornahme der Maßnahme. Es können eine oder mehrere Maßnahmen vorgenommen werden.

Die mindestens eine Maßnahme erhöht oder reduziert den Energieverbrauch des Fahrzeugs. Eine Korrelation zwischen Energieverbrauch und Gesundheitszustand besteht insofern, als viele den Energieverbrauch reduzierende Maßnahmen schlecht für den Gesundheitszustand sind, d.h. zu einer schnelleren Alterung von Komponenten führen. Umgekehrt gehen viele Maßnahmen zur Schonung von Komponenten mit einem erhöhten Energieverbrauch einher.

Das Verfahren kann isoliert für eine einzelne Fahrzeugkomponente durchgeführt werden, z.B. für einen internen Energiespeicher des Fahrzeugs, oder für einen Motorumrichter, oder für einen Batterie Chopper, oder für einen Trafo Eingangssteller, oder für eine Chopper Drossel, oder für einen Motor. Es ist jedoch auch möglich, das Verfahren auf mehrere Komponenten anzuwenden, d.h. bei der Entscheidung über die Durchführung von Maßnahmen gleichzeitig den Gesundheitszustand mehrerer Komponenten zu berücksichtigen.

Vorzugsweise erfolgt der Vergleich des Gesundheitszustands mit dem vorgegebenen Gesundheitszustand, indem aus dem Gesundheitszustand eine erwartete Lebensdauer ermittelt und mit einer vorgegebenen Lebensdauer verglichen wird. Diese Ermittlung der Lebensdauer kann mittels eines Prognoseverfahrens erfolgen. Hierbei können außer dem aktuellen Gesundheitszustand auch Gesundheitszustandswerte der Vergangenheit einbezogen werden, also eine zeitliche Entwicklung des Gesundheitszustands betrachtet werden.

Besonders vorteilhaft ist es, wenn im Fall, dass die erwartete Lebensdauer länger als die vorgegebene Lebensdauer ist, zumindest eine den Energieverbrauch beim Betreiben des Fahrzeugs verringernde Maßnahme vorgenommen wird, und/oder im Fall, dass die erwartete Lebensdauer kürzer als die vorgegebene Lebensdauer ist, zumindest eine den Energieverbrauch beim Betreiben des Fahrzeugs erhöhende Maßnahme vorgenommen wird. Dies erlaubt es, einen Ausgleich zwischen gegenläufigen Zielen zu finden: der Verlängerung der Lebensdauer einerseits, und der Energieeffizienz beim Betreiben des Fahrzeugs andererseits.

In Weiterbildung der Erfindung umfasst die mindestens eine den Energieverbrauch beim Betreiben des Fahrzeugs erhöhende Maßnahme:
- eine Erhöhung der Kühlerleistung zur Kühlung der Komponente, und/oder
- eine Verringerung der anfänglichen Zugkraft beim Beschleunigen des Fahrzeugs, und/oder
- eine Verringerung der Pulsfrequenz der Komponente, insbesondere die Verringerung der Pulsfrequenz eines Motorumrichters und/oder eines Batterie Choppers und/oder eines Trafo Eingangsstellers, und/oder
- eine Verringerung der Bremsleistung beim elektrischen Bremsen.

Die umgekehrten Maßnahmen hingegen, d.h. die Verringerung der Kühlerleistung, die Erhöhung der anfänglichen Zugkraft, die Erhöhung der der Pulsfrequenz, und die Erhöhung der Bremsleistung beim elektrischen Bremsen, reduzieren jeweils den Energieverbrauch.

Außer der Situation bzgl. des Gesundheitszustands kann die Vornahme der Maßnahme ferner abhängen von dem bei Vornahme der Maßnahme bewirkten Ausmaß der Erhöhung oder Verringerung des Energieverbrauchs. D.h. es kann betrachtet werden, welche Maßnahme sich wie stark auf die Änderung des Energieverbrauchs auswirkt, um zu entscheiden, welche Maßnahme in welchem Umfang durchgeführt werden soll. Hinsichtlich der Abschätzung der Stärke der Auswirkung kann auch für den Gesundheitszustand so vorgegangen werden: d.h. es kann betrachtet werden, welche Maßnahme sich wie stark auf die Änderung des Gesundheitszustands auswirkt, um zu entscheiden, welche Maßnahme in welchem Umfang durchgeführt werden soll.

Weitere Einflussgrößen dafür, welche Maßnahme(n) in welchem Umfang durchgeführt werden soll(en), können sein:
- die Beladung des Fahrzeugs, und/oder
- eine vorgegebene Fahrzeit, welche sich z.B. aus dem Ziel der Einhaltung des Fahrplans ergeben kann, und/oder
- die Außentemperatur, und/oder
- der Ladezustand eines internen Energiespeichers des Fahrzeugs, und/oder
- durch die Maßnahme verursachte Kosten, z.B. für Energie und/oder aufgrund von Komponentenalterung.

In Weiterbildung der Erfindung wird ein Gesundheitszustand einer zweiten Komponente mit einem zweiten vorgegebenen Gesundheitszustand verglichen, und abhängig zusätzlich vom Ergebnis dieses zweiten Vergleichs wird die zumindest eine den Energieverbrauch beim Betreiben des Fahrzeugs erhöhende oder verringernde Maßnahme vorgenommen. Es liegt also das Ergebnis eines ersten Vergleichs für eine erste Komponente vor, und eines zweiten Vergleichs für eine zweite Komponente. Die Vornahme der mindestens einen Maßnahme hängt von beiden Vergleichen ab. Dies ermöglicht es, den Gesundheitszustand zwischen zwei Komponenten zu balancieren, indem eine Alterung einer Komponente zu Lasten der Alterung einer anderen Komponente verringert werden kann. Um zu ermitteln, welche Komponente zulasten einer anderen an Gesundheitszustand verlieren darf, bietet sich wiederum ein Vergleich des ersten mit dem zweiten Gesundheitszustandsvergleich an.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt ablaufen. Das Computerprogramm veranlasst, die Schritte des Verfahrens auszuführen. Dies kann dadurch erfolgen, dass das Programm die mindestens eine vorzunehmende Maßnahme bestimmt und deren Durchführung als Vorschlag ausgibt, und gegebenenfalls nach Empfang eines entsprechenden Befehls die Durchführung der jeweiligen Maßnahme veranlasst. Alternativ hierzu kann das Programm nach der Bestimmung der mindestens einen Maßnahme direkt deren Durchführung veranlassen.

Im Folgenden wird die Erfindung anhand eines Ausführungsbeispiels näher erläutert. Dabei zeigen:
Figur 1: ein elektrisch angetriebenes Fahrzeug,
Figur 2: zwei Diagramme zur Verdeutlichung der Auswirkung einer Änderung der anfänglichen Zugkraft,
Figur 3: für verschiedene Linien den Gesundheitszustand SoH einer Komponente,
Figur 4: ein erster zeitlicher Verlauf des Gesundheitszustands SoH einer Komponente,
Figur 5: ein zweiter zeitlicher Verlauf des Gesundheitszustands SoH einer Komponente,
Figur 6: eine Regelung zur Performance Steuerung,
Figur 7: eine mögliche Temperaturabhängigkeit der Steuerung,
Figur 8: schematisch den Austausch von Lebensdauer zwischen verschiedenen Komponenten eines Traktionssystems,
Figur 9: Entladungszyklen einer Batterie.

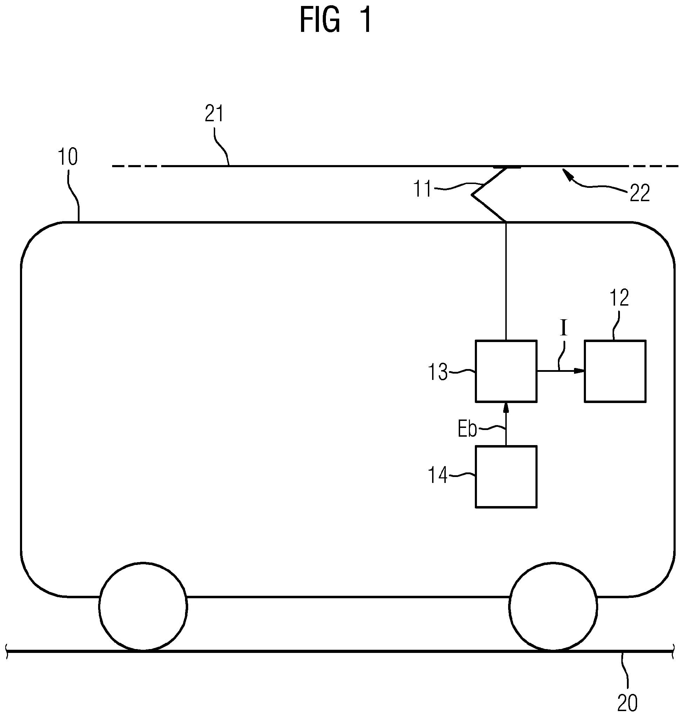

Figur 1 zeigt ein elektrisch angetriebenes Fahrzeug 10, das über einen oder mehrere Stromabnehmer 11 mit einer Stromschiene oder einer Oberleitung 21 eines externen Energieversorgungssystems 22 einer nur angedeuteten Strecke 20 in Verbindung steht. Bei dem Fahrzeug 10 handelt es sich vorzugsweise um ein Schienenfahrzeug. Es dient üblicherweise dem Transport von Passagieren. Der Übersichtlichkeit halber ist der Passagierraum nicht in der Figur dargestellt.

Das Fahrzeug 10 umfasst einen internen Energiespeicher 12, der die zum Befahren von nichtelektrifizierten Streckenabschnitten benötigte Fahrenergie zur Verfügung stellt. Im Folgenden wird davon ausgegangen, dass es sich bei dem Energiespeicher um eine aufladbare Batterie bzw. ein System aus vielen aufladbaren Batterien handelt. Anstelle einer Traktionsbatterie können grundsätzlich auch andersartige Energiespeicher zum Einsatz kommen, wie z.B. Hochleistungskondensatoren.

Die Verwendung von batterieangetriebenen Zügen ist vorteilhaft, da sie Dieselfahrzeuge ersetzen können, welche ansonsten auf nicht elektrifizierten Strecken zum Einsatz kommen. Hierdurch wird der unerwünschte Schadstoffausstoß von Dieselfahrzeugen vermieden. Die elektrische Traktion mittels Batterie weist ähnliche Eigenschaften wie die Dieseltraktion auf, nämlich eine hohe Zugkraft bei eher geringer Leistung. Dies entspricht der Möglichkeit einer hohen Beschleunigung und dem Fahren mit nicht allzu hoher konstanter Geschwindigkeit nach Abschluss der Beschleunigung. Diese Anforderung wird an viele Regionalzüge gestellt, welche entlegene nicht elektrifizierte Strecken befahren, auf welchen keine hohen Geschwindigkeiten möglich sind.

Der Energiespeicher 12 wird während des Befahrens von elektrifizierten Streckenabschnitten über ein Ladegerät 13 mittels eines Ladestroms I aufgeladen. Die elektrische Energie zum Laden kann über den Stromabnehmer 11 aus dem externen Energieversorgungssystem 22 entnommen werden. Dies geschieht an Haltepunkten, die in elektrifizierten Streckenabschnitten liegen, an Oberleitungsinselanlagen, die einzelne Haltepunkte über eine Oberleitung in einem begrenzten Bereich versorgen, sowie während der Fahrt unter einem Fahrdraht. Alternativ kann die Aufladung des Energiespeichers 12 über einen Antrieb 14 erfolgen, wenn beim Bremsen des Fahrzeugs 10 Bremsenergie Eb zur Verfügung steht, also durch regenerativ zurückgewonnene elektrische Energie. Der Antrieb 14 kann eine oder auch mehrere Antriebseinheiten aufweisen.

Die im Folgende beschriebene Erfindung ist auf solch ein Schienenfahrzeug mit internem Energiespeicher 12 anwendbar, ferner auch auf Schienenfahrzeuge ohne internen Energiespeicher, und auch auf andersartige (Nicht-Schienen) Fahrzeuge.

Für batterieangetriebene Fahrzeuge ist der Energiespeicher 12 eine wesentliche Komponente. Dessen Alterungszustand, auch als Lebensalter des Energiespeichersystems bezeichnet, kann aus der Kapazität oder anderen Parametern, wie beispielsweise dessen Innenwiderstand abgeleitet werden. Es sind Algorithmen bekannt, um den Alterungszustand zu bestimmen. Der Alterungszustand des Energiespeichers, aber auch anderer Komponenten des Fahrzeugs, wird im Folgenden als SoH (State of Health) bezeichnet. Hierbei ist 100% neuwertig. Üblicherweise wird bei ca. 80% der kritische Alterungszustand erreicht, bei der man aus Sicherheitsgründen oder zur Sicherstellung eines einwandfreien Betriebs die Komponente außer Betrieb nehmen und gegen eine neue austauschen sollte. Alternativ kann man den kritischen Alterungszustand bei 0% definieren. Unabhängig von der Definition des SoH ist beim kritischen Alterungszustand noch immer eine Funktionsfähigkeit gegeben, beim Energiespeicher ist also die Fähigkeit vorhanden, Energie zu speichern oder abzugeben.

Außer der Batterie 12 umfasst ein das Fahrzeug 10 weitere Komponenten, welche im Laufe des Betriebs altern. Für deren SoH gilt ähnliches wie für den Energiespeicher 12 beschrieben. Hinsichtlich des SoH werden außer der Batterie die folgenden Komponenten betrachtet:
- Motorumrichter, insbesondere ein PWR (Pulswechselrichter): basierend auf der vom Gleichstromzwischenkreis des Traktionssystems gelieferten Spannung stellt diese Komponente die vom Motor benötigte Wechselspannung zur Verfügung.
- Batterie Chopper, üblicherweise ein DC/DC-Converter: dieser passt das Batteriespannungsniveau, welches meist im Niederspannungsbereich liegt, an das höhere Spannungsniveau des DC Zwischenkreises des Traktionsteilsystems an.
- Trafo Eingangssteller, z.B. ein 4 Quadrantensteller: dieser bringt die vom Stromabnehmer gelieferte Einspeisespannung auf das Spannungsniveau des Gleichstromzwischenkreises des Traktionssystems.
- Chopper Drossel: diese Filterdrossel mit Glättungskondensator, die im Zusammenhang mit dem Batterie Chopper notwendig ist, dient der Glättung der Stromwelligkeit.
- Motor zum Antrieb der Räder,
- Hilfsbetriebe: diese Einrichtungen dienen der Versorgung des elektrischen Bordnetzes, stellen also die Betriebsfähigkeit außer dem eigentlichen Fahren sicher.

Diese Komponenten sind i.d.R. mehrfach pro Fahrzeug vorhanden.

Es wird davon ausgegangen, dass für die betrachteten Komponenten der aktuelle Istzustand des SoH bekannt ist, sowie der Verlauf des SoH in der Vergangenheit. Bei Halbleitern, welche die für den SoH relevanten Bestandteile von Motorumrichter, Batterie Chopper und Trafo Eingangssteller sind, hängt der SoH z.B. maßgeblich von der Höhe und Häufigkeit von Temperaturhüben ab, die nach geeigneten Verfahren gezählt und in einen Lebensdauerverbrauch umgerechnet werden können. Hierfür können geeignete Algorithmen und Modelle zum Einsatz kommen, welche nicht Gegenstand der Erfindung sind.

Beim Betrieb des Fahrzeugs ist zu berücksichtigen, dass Maßnahmen zur Steigerung der Energieeffizienz oder Performance, was ein erstrebenswertes Ziel darstellt, üblicherweise den SoH zumindest mancher Komponenten ungünstig beeinflussen, d.h. sich in einem großen Lebensdauerverbrauch auswirken. Diese gegenläufigen Auswirkungen verschiedener Maßnahmen, einerseits auf die Energieeffizienz, andererseits auf den Lebensdauerverbrauch, werden im Folgenden erläutert:

### Erste Maßnahme: Erhöhung der Kühlerleistung

Dies wirkt sich negativ auf den Energieverbrauch aus, da Energie für das Zur-Verfügung-Stellen der Kühlerleistung aufzuwenden ist. Dabei ist zu beachten, dass die zu erreichende Kühltemperatur von äußeren Zuständen, insbesondere der Umgebungstemperatur, abhängt, welche durch die Tages- und Jahreszeit beeinflusst wird.

Als Sekundäreffekt hinsichtlich des Energieverbrauchs sinken bei Erhöhung der Kühlerleistung die Energieverluste der meisten Komponenten, und zwar sowohl die Halbleiter- als auch die Filterdrossel- und Motorverluste. Dies lässt sich grundsätzlich dadurch erklären, dass bei sinkender Temperatur die Widerstände sinken, was den Energieverbrauch reduziert. Diese positive energetische Auswirkung der Erhöhung der Kühlerleistung ist jedoch i.d.R. geringer als der Primäreffekt des durch das Bewirken der Kühlung gesteigerten Energieverbrauchs. Das konkrete Ausmaß des Sekundäreffekts hängt u.a. vom verwendeten Kühlmedium ab, d.h. davon, welche Temperaturreduktion mit einer bestimmten Kühlerleistung erreicht werden kann.

Dieser Sekundäreffekt der Verlustverminderung durch Kühlung ritt nicht bei der Batterie auf. Hier ist eine hohe Temperatur energetisch vorteilhaft. Da die Batteriekühlung normalerweise unabhängig von der Kühlung der anderen Komponenten ist, kann hinsichtlich der Kühlung der Batterie unabhängig von der Kühlung der anderen Komponenten vorgegangen werden.

Auf den SoH der oben genannten Komponenten wirkt sich die Maßnahme vorteilhaft auf, d.h. durch eine gesteigerte Kühlung wird der Lebensdauerverbrauch reduziert. Das Ausmaß der Auswirkung hängt von dem Aufbau der Komponenten ab. Grundsätzlich gilt, dass Wärme zu einer schnelleren Alterung führt. Dies gilt am meisten bei den halbleiterbasierten Bestandteilen, also Motorumrichter, Batterie Chopper und Trafo Eingangssteiler, aber auch bei dem Energiespeicher, und in geringerem Maße für die drosselartigen Komponenten, d.h. Chopper Drossel und Motor.

Diese positive SoH Beeinflussung der gesteigerten Kühlung tritt nicht nur beim Fahren auf, sondern auch beim Stand: Kühlmaßnahmen eignen sich auch für das Laden des Energiespeichers oder das Betreiben von Hilfsbetrieben beim Stillstand des Fahrzeugs.

### Zweite Maßnahme: Erhöhung der Zugkraft

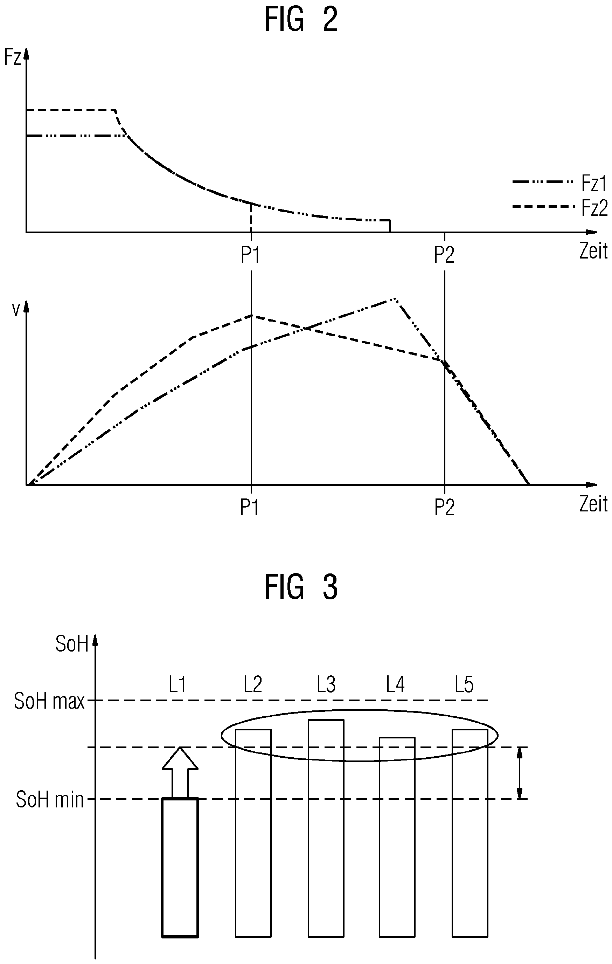

Dies wirkt sich positiv auf den Energieverbrauch aus, was sich anhand der beiden Graphen von Figur 2 erkennen lässt. Im oberen Graphen ist der Verlauf der Zugkraft Fz über der Zeit aufgetragen, im unteren der zugehörige Verlauf der Geschwindigkeit v des Fahrzeugs. Zunächst wird das Fahrzeug vom Stillstand aus mit maximaler, konstanter Zugkraft beschleunigt, wobei der zweite Verlauf Fz2 für eine gegenüber dem ersten Verlauf Fz1 gesteigerte Zugkraft steht. Gesteigert ist bei dem zweiten Verlauf Fz2 also die maximale Zugkraft, welche zu Beginn bei der Beschleunigung des Fahrzeugs vom Stillstand aus aufgewendet wird. Bei Erreichen der maximalen Leistung wird die Zugkraft auf der jeweiligen Leistungshyberbel reduziert. Da die maximale Leistung bei den beiden Verläufen Fz1 und Fz2 gleich ist, ist der Verlauf der Zugkraft auf den beiden Leistungshyberbeln identisch. Vor Erreichen der Haltestelle wird der Bremsvorgang eingeleitet, so dass das Fahrzeug schließlich wieder zum Stillstand kommt.

Bei dem zweiten Verlauf Fz2 wird aufgrund der höheren anfänglichen Zugkraft schneller eine höhere Geschwindigkeit erreicht, so dass die Zugkraft zum Zeitpunkt P1 auf null reduziert werden kann. Zwischen den beiden Punkten P1 und P2, wo bei dem zweiten Verlauf Fz2 der Bremsvorgang begonnen wird, findet dementsprechend bei dem zweiten Verlauf Fz2 eine Rollphase statt. Da während der Rollphase der Antrieb abgeschaltet werden kann, ist dies energetisch sehr vorteilhaft.

Demgegenüber ist - um zur gleichen Zeit wie beim zweiten Verlauf Fz2, also gemäß Fahrplan, an der Haltestelle anzukommen - bei dem ersten Verlauf Fz1 ein längerer Beschleunigungsvorgang nötig, da dieser verlangsamt ist. Dies führt zu einer erhöhten Geschwindigkeit, weshalb auch der Fahrwiderstand erhöht ist. Außerdem entfällt die Rollphase - wie in der Figur gezeigt - vollständig, oder in weniger extremen Fällen fällt sie zumindest kürzer aus. Daher erfordert das Fahren mit einer reduzierten Zugkraft gemäß dem ersten Verlauf Fz1 einen höheren Energieaufwand als dasjenige mit höherer anfänglicher Zugkraft gemäß dem zweiten Verlauf Fz2.

Für den SoH jedoch ist die Zugkrafterhöhung negativ: die Zugkraft ist in etwa proportional zum Motorstrom. Da der Strom mit einer Temperaturerhöhung einhergeht, führt die Zugkrafterhöhung zu einem erhöhten Lebensdauerverbrauch. Dies betrifft hauptsächlich den Motorumrichter.

Als Sekundäreffekt auf der energetischen Seite führt der erhöhte Motorstrom zu gesteigerten Motorverlusten, wodurch der Energieverbrauch gesteigert wird. Dies gilt im Bereich der konstanten Zugkraft, also vor Erreichen der Leistungshyperbel. Dieser Effekt ist jedoch i.d.R. geringer als die oben erläuterte Energieeinsparung aufgrund der energieeffizienteren Fahrweise mit höherer Zugkraft.

### Dritte Maßnahme: Erhöhung der Pulsfrequenz des Motorumrichters

Dies wirkt sich positiv auf den Energieverbrauch aus. Denn durch die gesteigerte Taktung ist der zeitliche Verlauf des Motorstroms geglättet. Dies reduziert die Stromoberschwingungen und damit die Motorverluste. Eine niedrigere Pulsfrequenz des Motorumrichters hingegen führt zu einem weniger runden Verlauf des Motorstromes und des Motormomentes, welche in diesem Fall mehr einer Überlagerung einer Sinuskurve mit Oberwellen entspricht. Dies ruft größere Motorverluste hervor.

Als Sekundäreffekt treten bei der Erhöhung der Pulsfrequenz zwar erhöhte Halbleiterverluste am Umrichter auf; jedoch überwiegt bei modernen Halbleitern der positive Energieeinsparungseffekt an der angeschlossenen passiven Komponente, also am Motor, den Mehrverbrauch am Umrichter.

Hinsichtlich des SoH des Motorumrichters wirkt sich die Erhöhung seiner Pulsfrequenz jedoch negativ aus: eine häufigere Taktung erhöht den Lebensdauerverbrauch.

### Vierte Maßnahme: Erhöhung der Pulsfrequenz des Batterie Choppers

Hier gilt entsprechendes wie bei der dritten Maßnahme: Energetisch vorteilhaft wirkt sich aus, dass bei der Chopper Drossel die Verluste durch die gesteigerte Taktung reduziert werden. Der Sekundäreffekt der gleichzeitig gesteigerten Halbleiterverluste bei der aktiven Komponente ist geringer.

Der SoH der aktiven Komponente, also des Batterie Choppers, wird durch die häufigere Taktung negativ beeinflusst, der Lebensdauerverbrauch nimmt zu.

### Fünfte Maßnahme: Erhöhung der Pulsfrequenz des Trafo Eingangssteller

Hier gilt entsprechendes wie bei der vierten Maßnahme: Energetisch vorteilhaft wirkt sich aus, dass beim Netztrafo oder alternativ bei dem Netzfilter die Verluste durch die gesteigerte Taktung reduziert werden. Der Sekundäreffekt der gleichzeitig gesteigerten Halbleiterverluste bei der aktiven Komponente ist i.d.R. bei modernen Bauelementen geringer. Der SoH der aktiven Komponente, also des Trafo Eingangsstellers, wird durch die häufigere Taktung negativ beeinflusst, der Lebensdauerverbrauch nimmt zu.

### Sechste Maßnahme: Erhöhung der Bremsleistung

Beim elektrischen Bremsen kann die Bremsenergie vom Energiespeicher oder dem externen Versorgungsnetz aufgenommen werden. Diese Energierekuperation entspricht daher einer Reduzierung des Energieverbrauchs. Außerdem reduziert eine erhöhte elektrische Bremsleistung die dissipative Bremsleistung mechanischer Bremsaggregate.

Die erhöhte Bremsleistung resultiert sowohl in einer Erhöhung der Stromstärke als auch der Spannung des Gleichstromzwischenkreises. Die Stromerhöhung bewirkt eine Temperaturerhöhung, welche sich negativ auf den SoH der verbundenen Komponenten, insbesondere bei dem Batterie Chopper und dem Trafo Eingangssteller, auswirkt.

Als Sekundäreffekt auf der energetischen Seite werden die Batterieverluste und die Verluste von Chopperdrossel und Batterie Chopper bzw. beim Einspeisen in das externe Netz die Verluste von Trafo und Trafo Eingangsteller erhöht. Das Ausmaß dieser Verluste hängt von der Erhöhung von Stromstärke und Spannung im Gleichstromzwischenkreis ab. Dies bedeutet, dass bei starkem Bremsen auch eine starke Erhöhung der Verluste eintritt, da diese stärker als linear mit der Stromstärke ansteigen. Dementsprechend kann es sein, dass bei starkem Abbremsen die Sekundäreffekte sogar die Energierekuperation überwiegen; eine Erhöhung der Energieeffizienz durch gesteigerte Bremsleistung ist daher am meisten bei einer Steigerung der Bremsleistung bis zu einer bestimmten Grenze zu erwarten.

Eine weitere Maßnahme, welche sich sowohl hinsichtlich der Energieeffizienz als auch hinsichtlich des SoH negativ auswirkt, ist die Erhöhung der Beschleunigungsleistung. Eine Erhöhung der Beschleunigungsleistung entspräche in Figur 2 - nicht in der Figur dargestellt - einem Verschieben der Leistungshyberbeln der Zugkraftverläufe nach oben.

Wie bei der Erhöhung der Bremsleistung erläutert, resultiert auch die Erhöhung der Beschleunigungsleistung sowohl in einer Erhöhung der Stromstärke als auch der Spannung des Gleichstromzwischenkreises. Dies bedeutet eine Erhöhung der Batterieverluste, und der Verluste von Chopperdrossel und Batterie Chopper bzw. der Verluste von Trafo und Trafo Eingangsteller. Auch bewirkt die Stromerhöhung eine Temperaturerhöhung, welche sich negativ auf den SoH von Batterie Chopper und dem Trafo Eingangssteller auswirken.

Obwohl wie beschrieben die Erhöhung der Beschleunigungsleistung ungünstig für den Energie- und den Lebensdauerverbrauch ist, ist es zeitweise sinnvoll, diese Maßnahme durchzuführen. Denn hierdurch kann Fahrtzeit eingespart und dadurch der Fahrplan leichter eingehalten werden.

Die oben beschriebenen Maßnahmen können gezielt eingesetzt werden, um eine Balance zwischen den beiden Zielen der Verlängerung der Lebensdauer und dem niedrigen Energieverbrauch zu finden. Hierbei kann die Betriebsweise des Fahrzeugs zwischen Energie optimiert und Lebensdauer optimiert dynamisch situativ derart angepasst werden, so dass sich der Lebensdauerverbrauch mittelfristig nach einer vorberechneten Plankurve einstellt und er sich damit auf allen Linien tendenziell ähnlich verhält. Energieverbrauch und Komponentenlebensdauer werden dabei gegeneinander abgewogen. Anspruchslosere Linien werden auf niedrigen Energieverbrauch eingestellt, während anspruchsvolle Linien auf geringen Lebensdauerverbrauch eingestellt werden. Dies kann so erfolgen, dass sich die Erhöhung im Gesamtenergieverbrauch dabei im kleinen einstelligen Prozentbereich beläuft.

Figur 3 zeigt schematisch die Auswirkung dieser Vorgehensweise auf den SoH einer Komponente. Dieser ist nach oben aufgetragen, wobei SoH max dem Zustand der neuwertigen Komponente entspricht, und SoH min dem Zustand, welchen die Komponente zu einem bestimmten Zeitpunkt mindestens aufweisen sollte. Jeder Balken steht für den SoH Zustand, welchen die Komponente ausgehend von dem Zustand SoH max haben würde, wenn das Fahrzeug eine gewisse Zeit auf einer bestimmten Linie L1, L2, L3, L4 oder L5 gefahren wäre. Bei der ersten Linie L1 handelt es sich um eine anspruchsvolle Linie, d.h. das Befahren dieser Linie geht mit einem hohen Lebensdauerverbrauch einher. Nach dem Stand der Technik wird derart vorgegangen, dass der erhöhte Lebensdauerverbrauch auf anspruchsvollen Linien und damit der Tausch von Bauteilen einkalkuliert wird. Hohe Service- und Materialkosten sind die Folge; außerdem ist der häufige Komponentenaustausch schädlich für die Umwelt.

Besser ist es, die oben genannten Maßnahmen auf der ersten Linie L1 derart einzusetzen, dass der SoH auf SoH min angehoben wird. D.h. die erste Linie L1 wird in Bezug auf die Lebensdauer schonend und damit energetisch ungünstiger gefahren. Diese Fahrweise sollte aber nur dann zum Einsatz kommen, wenn dies mit dem Fahrplan und den aktuellen Gegebenheiten kompatibel ist. Wenn hingegen das Fahrzeug stark beladen oder die Fahrplaneinhaltung gefährdet ist, musss eine bestimmte Mindestbeschleunigung möglich sein, auch wenn dies für den SoH der Komponente ungünstig ist.

Es gibt verschiedene Faktoren, die eine Strecke zu einer anspruchsvollen Strecke machen können. Beispiele hierfür sind Steigungen oder kurze Haltestellenabstände. Statt des Fahrens auf anspruchsvoller Strecke L1 kann auch das Fahren unter hoher Belastung den schnellen Lebensdauerverbrauch hervorrufen. Dies kann z.B. durch Umwelteinflüsse wie nasses oder windiges Wetter oder starke Beladung, z.B. zur Rushhour, herrühren.

Die normale Betriebsweise des Fahrzeugs ist an den durchschnittlichen Linien L2, L3, L4, L5 und an den normalerweise herrschenden Belastungen orientiert. Hier wirkt der ausgelegte Energieverbrauch. Dieser optimale Energieverbrauch wird nur bei anspruchsvollen Linien bzw. widrigerer Belastung nicht erbracht, d.h. für die anspruchsvollen Linien ist eine andere Einstellung vorgesehen.

Durch einen Linientausch, d.h. dadurch, dass die Fahrzeuge einer Flotte als rollierendes System abwechselnd die verschiedenen Linien befahren, stellt sich nicht zwangsläufig ein Mittelwert des SoH für jedes Fahrzeug ein. Denn die genaue Entwicklung der Lebensdauer lässt sich nicht zielgenau steuern, da die statistischen Einflussgrößen auf den SoH wie Beladung oder Temperatur im Voraus nur abgeschätzt aber nicht vorhergesagt werden können, und dazu noch unvorhergesehene Änderung im Verlauf des Betriebes über mehrere Jahre kommen. Z.B. kann es sein, dass beim Betrieb auf einer anspruchsvollen Strecke günstige Umweltbedingungen oder niedrige Beladung zum Tragen kommen oder umgekehrt und damit der Istzustand sich anders verhält als in der Auslegung angenommen. Außerdem ziehen die anspruchsvollen Linien die Lebensdauer im Mittel nach unten, was unter dem Strich zu erhöhtem Lebensdauerverbrauch bzw. Servicekosten der gesamten Flotte führt. Daher ist ein Regeleingriff, wie er im Folgenden erläutert wird, sinnvoll.

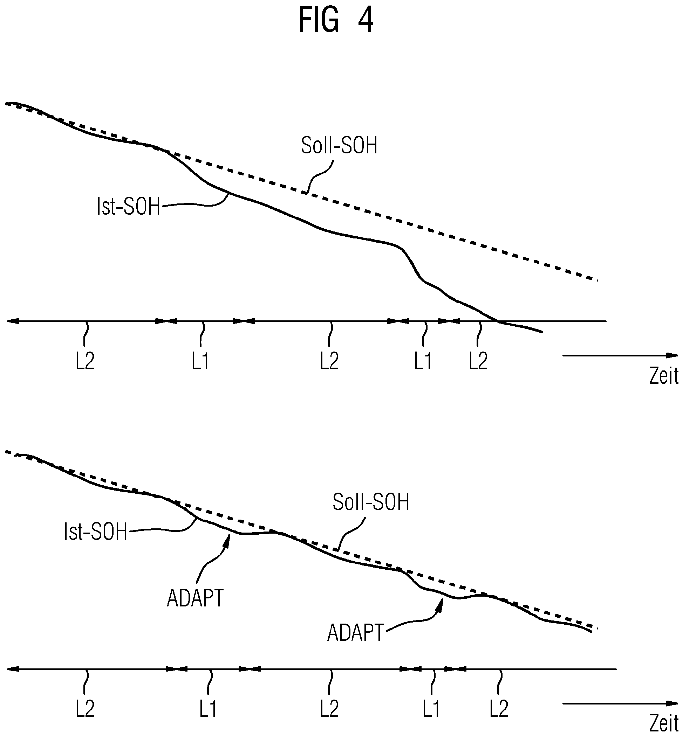

Figur 4 zeigt den Lebensdauerverlauf einer Komponente eines Fahrzeugs, das abwechselnd auf der ersten Linie L1, welche anspruchsvoll ist, und einer zweiten durchschnittlichen Linie L2 fährt, wobei der SoH nach oben aufgetragen ist. Die durchgezogene Kurve Ist-SoH zeigt den tatsächlichen Verlauf des SoH. Dieser Verlauf kann anhand geeigneter Eingangsdaten, wie z.B. den Verlauf der Chiptemperatur bei Halbleiterkomponenten, gewonnen werden. Es ist zu sehen, dass der tatsächliche SoH Verlauf Ist-SoH beim Befahren der anspruchsvollen Linie L1 stärker abfällt als bei der durchschnittlichen Linie L2. Die gepunktete Kurve zeigt einen vorgegebenen SoH Verlauf Soll-SoH. Der Vergleich der beiden SoH Verläufe Ist-SoH und Soll-SoH ergibt, dass die im oberen Teil der Figur 4 gezeigte Betriebsweise des Fahrzeugs zu einem vorzeitigen Lebensdauerende der Komponente gegenüber dem vorgegebenen Lebensdauerende des Verlaufs Soll-SoH führen würde. Das Lebensdauerende ist hierbei erreicht, wenn die SoH Kurve die Zeit-Achse schneidet. Es wäre also sehr früh eine Auswechslung der Komponente notwendig.

Daher ist vorgesehen, bei Befahren der anspruchsvollen Linie L1 eine Anpassung ADAPT vorzunehmen, bei welcher die oben beschriebenen Maßnahmen derart durchgeführt werden, dass sie sich auf Kosten des Energieverbrauchs positiv auf den Lebensdauerverbrauch auswirken. Es werden also SoH fördernde Maßnahmen eingeleitet, die den erhöhten Lebensdauerverbrauch mindern, was umgekehrt aber mit erhöhtem Energieverbrauch verbunden ist. Auf diese Weise kann der tatsächliche SoH Verlauf Ist-SoH in etwa in Übereinstimmung mit der Vorgabe Soll-SoH gebracht werden.

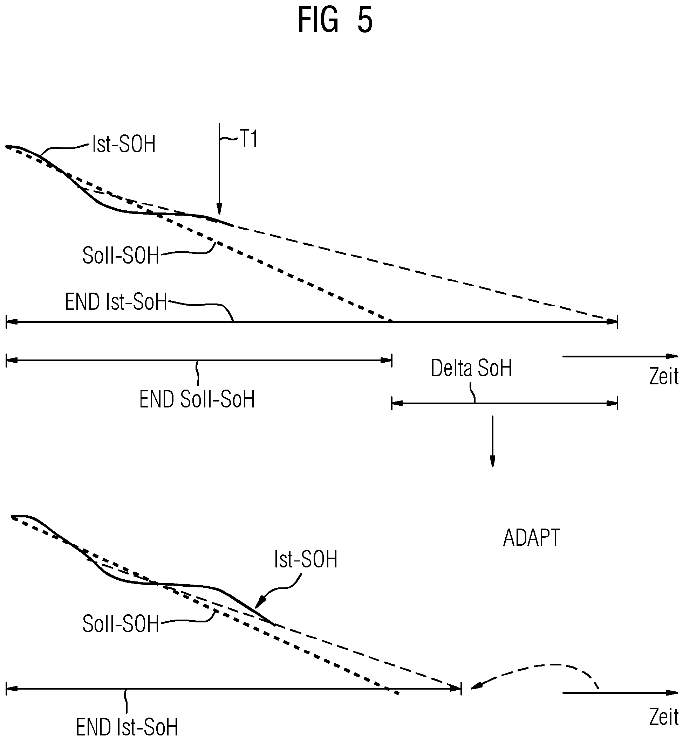

Figur 5 zeigt den umgekehrten Fall, wonach eine SoH Reserve vorhanden ist, d.h. der tatsächliche Lebensdauerverbrauch gemäß dem Verlauf Ist-SoH ist kleiner als gemäß dem Verlauf Soll-SoH in der Auslegung geplant. In Figur 5 ist ferner dargestellt, dass zum Zeitpunkt T1 eine Prognose des tatsächlichen SoH Verlauf Ist-SoH erfolgt. Hierdurch kann das prognostizierte Ende END Ist-SoH des tatsächlichen SoH Ist-SoH bestimmt werden. Durch Vergleich mit dem geplanten Lebensdauerende END Soll-SoH ergibt sich die Lebensdauerreserve Delta SoH. Es wird nun eine Anpassung ADAPT vorgenommen, bei welcher die oben beschriebenen Maßnahmen in der Weise durchgeführt werden, dass sie sich zugunsten des Energieverbrauchs negativ auf den Lebensdauerverbrauch auswirken. Hierdurch kann der tatsächliche SoH Verlauf Ist-SoH in etwa in Übereinstimmung mit der Vorgabe Soll-SoH gebracht werden, wobei durch die den Energieverbrauch optimierende Maßnahmen eine energiesparende Betriebsweise des Fahrzeugs ermöglicht wird.

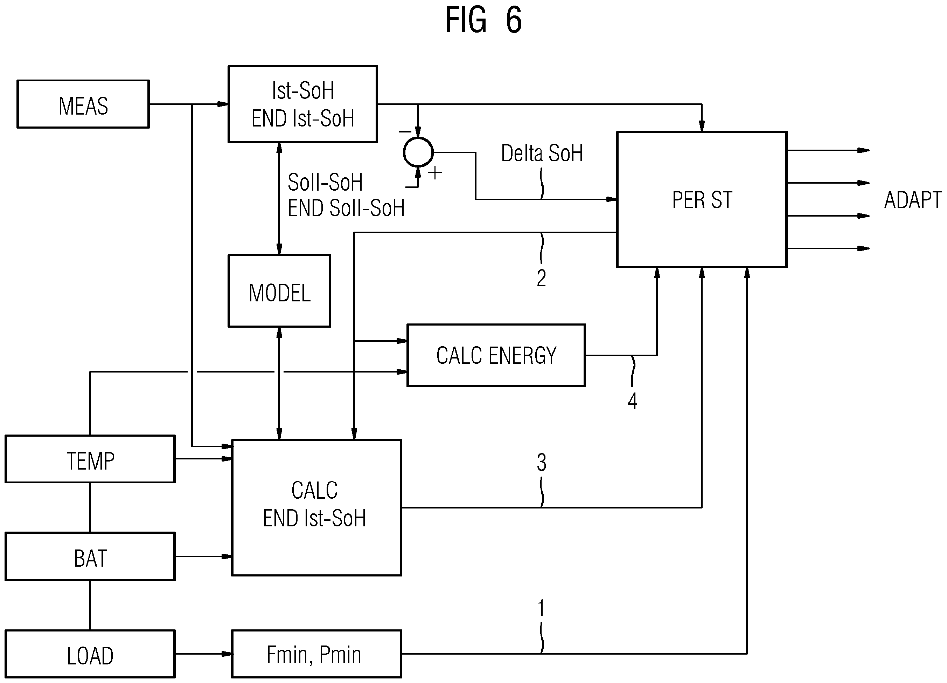

Figur 6 zeigt eine Regelung zur Performance Steuerung, mit welcher die erläuterte Vorgehensweise realisiert werden kann. Die Performance Steuerung PER ST entscheidet, welche Anpassung ADAPT vorzunehmen ist. Bei der Anpassung ADAPT kann es sich um eine oder mehrere der oben erläuterten Maßnahmen handeln, also Veränderung der Pulsfrequenzen und/oder Veränderung der maximalen Zugkraft und/oder Veränderung der maximalen Leistung bei Bremsen oder Beschleunigen und/oder Veränderung der Kühlleistung. Bei dem im Folgengen erläuterten kann nur eine einzelne Komponente in Blick genommen werden; alternativ können mehrere Komponenten betrachtet und hinsichtlich ihres SoH und der Auswirkung der Maßnahmen hierauf analysiert werden.

Auf der linken Seite sind die vier Istwerte dargestellt, welche der Steuerung zugrunde gelegt werden. Hierbei handelt es sich u.a. um Messwerte MEAS, welche für die Bestimmung des tatsächlichen SoH Ist-SoH eingesetzt werden. Es kann der aktuelle tatsächliche SoH Ist-SoH mit einem vorgegebenen aktuellen SoH Soll-SoH verglichen werden. Zusätzlich oder alternativ kann anstelle des Vergleichs der aktuellen Werte ein Vergleich des Lebensdauerendes erfolgen. Hierzu wird ein Lebensdauermodell MODEL verwendet, um das tatsächliche Lebensdauerende END Ist-SoH zu prognostizieren. Dieses prognostizierte tatsächliche Lebensdauerende END Ist-SoH wird mit dem Solllebensdauerende END Soll-SoH verglichen, um die Abweichung Delta SoH zu erhalten, welche der Performance Steuerung PER ST zur Verfügung gestellt wird.

Die Abweichung Delta SoH kann positiv sein, was bedeutet, dass eine Lebensdauerreserve vorhanden ist, so dass ein energieeffizienterer Betrieb zulasten des SoH möglich ist. Ist die Abweichung Delta SoH hingegen negativ, sollte gegenteilige vorgegangen werden, um einen verfrühten Austausch der betroffenen Komponente zu vermeiden.

Bei der Ermittlung der Maßnahmen zur Anpassung ADAPT ist zu berücksichtigen - s. Punkt 1 in der Figur -, wie die aktuelle Beladung LOAD des Fahrzeuges ist. Denn hieraus ergibt sich eine mindestens notwendige Zugkraft Fmin und mindestens notwendige Leistung Pmin. Die Berechnung dieser Größen kann durch ein an sich bekanntes Fahrerassistenzsystem erfolgen. Die Anpassung ADAPT darf also nicht derart sein, dass diese aufgrund der aktuellen Beladung notwendige Zugkraft/Leistung nicht bereitgestellt werden kann.

Wie anhand der Figuren 4 und 5 erläutert, soll versucht werden, den Verlauf der Ist-SoH Kurve möglichst mit der Vorgabe Soll-SoH in Übereinstimmung zu bringen. Um zu entscheiden, welche Anpassung ADAPT hierfür in welchem Ausmaß durchzuführen ist, muss berechnet werden, in welchem Ausmaß sich die betrachteten Maßnahmen auf das prognostizierte tatsächliche Lebensdauerende END Ist-SoH auswirkt. Diese Berechnung CALC END Ist-SoH wird für die verschiedenen Maßnahmen durchgeführt, indem die anvisierten Zustandsänderungen vorgegeben werden - s. Punkt 2 in der Figur -, wonach - s. Punkt 3 in der Figur - der Einfluss der Maßnahmen auf den Lebensdauerverbrauch an die Performance Steuerung PER ST rückgemeldet wird.

In die Berechnung CALC END Ist-SoH geht das Lebensdauermodell MODEL ein, sowie die Istwerte TEMP und BAT. Bei dem Istwert TEMP handelt es sich um Außentemperaturdaten. Denn wie bei der Maßnahme der Veränderung der Kühlleistung erläutert, sind niedrigere Temperaturen förderlich für den SoH. Bei dem Istwert BAT handelt es sich um den Batterieladezustand und die damit verbundene Batterie-Leerlaufspannung. Für die Lebensdauerermittlung CALC END Ist-SoH ist die Batterie-Leerlaufspannung besonders relevant, da sie den notwendigen Batterie-Strom bestimmt. Diese Leerlaufspannung hat damit über den Maximalstrom Einfluss auf die zum Energiespeicher zugehörigen Komponenten, insbesondere den Batterie Chopper; so ist bei niedriger Spannung der über den Batterie Chopper fließende zur Erzielung einer bestimmten Leistung nötige Strom höher.

Bei einem batterieangetriebenen Fahrzeug ist insbesondere zu berücksichtigen, wie viel Energie für das Fahren verbraucht wird, da ansonsten möglicherweise die nächste Auflademöglichkeit nicht erreicht wird. Um in diesem Zusammenhang zu entscheiden, welche Anpassung ADAPT durchzuführen ist, muss ferner also auch berechnet werden, in welchem Ausmaß sich die betrachteten Maßnahmen auf den Energieverbrauch auswirken. Diese Berechnung CALC ENERGY wird für die verschiedenen Maßnahmen durchgeführt, indem die anvisierten Zustandsänderungen vorgegeben werden - s. Punkt 2 in der Figur -, wonach - s. Punkt 4 in der Figur - der Einfluss der Maßnahmen auf den Energieverbrauch an die Performance Steuerung PER ST rückgemeldet wird.

In die Berechnung CALC ENERGY gehen die Istwerte LOAD, TEMP und BAT ein. Denn der Energieverbrauch steigt mit zunehmender Beladung LOAD des Fahrzeugs. Ferner hängt der Energieverbrauch sowohl von dem Ladezustand der Batterie als auch von deren Innenwiderstand ab. Schließlich beeinflusst die Außentemperatur die Verluste verschiedener Komponenten.

Auch unabhängig vom Energiebedarf beim Fahren auf nichtelektrifizierter Strecke, also unabhängig vom begrenzten Batterieenergieinhalt, ist die Rückmeldung des Einflusses von Maßnahmen auf den Energieverbrauch an die Performance Steuerung PER ST sinnvoll. Denn hierdurch kann abgeschätzt werden, was die jeweilige Maßnahme an Energieeinsparung generell bringt, also eine Aufwand (Lebensdauer) zu Nutzen (Energieeinsparung) Abschätzung durchgeführt werden.

Ein in Figur 6 nicht dargestellter Aspekt ist das Einhalten des Fahrplans. Vor dem Umsetzen von Maßnahmen ist stets zu prüfen, ob sich die Fahrzeit hierdurch nicht in einer Weise ändert, dass der Fahrplan nicht mehr eingehalten werden kann.

Es wurde erläutert, wie von der Performance Steuerung PER ST die beiden Zielgrößen des prognostizierten tatsächlichen Lebensdauerendes END Ist-SoH und des Energieverbrauchs verwendet werden, um über die durchzuführenden Maßnahmen ADAPT zu entscheiden. Zusätzlich ist es möglich, den Aspekt der Wirtschaftlichkeit mit einzubeziehen. So können Kostenfunktionen eingesetzt werden, und zwar sowohl für die Energie als auch für den Austausch von Komponenten. Auf diese Weise kann abgewogen werden, ob ein schonender Komponentenverbrauch oder die Energieverlustreduzierung mehr Wert ist. So kann der Energiepreis sich ändern, was über eine online Übertragung in die Performance Steuerung PER ST eingegeben werden kann. Ähnlich könnte mit Service- und Komponentenpreisen verfahren werden. Ferner kann z.B. die Außentemperatur eine Parameterverschiebung hervorrufen, da bei kühleren Außentemperaturen die Komponente höher ausgenutzt werden kann, gleichzeitig der Energieverbrauch durch Fahrgastraumheizung steigt und damit Energie sparende Maßnahmen eher Sinn machen.

### Konkretes Beispiel: Veränderung der Zugkraft, insbesondere abhängig vom Beladungszustand LOAD

Wenn die Größe Delta SoH anzeigt, dass eine Lebensdauerreserve vorhanden ist, kann die Zugkraft erhöht werden. Im Beispiel der Figur 2 kann die anfängliche Zugkraft des Verlaufs Fz1 z.B. um ca 30% angehoben werden. Im umgekehrten Fall wird sie nur dann abgesenkt, wenn es vom Beladungszustand LOAD und von der von einem etwaigen Fahrerassistenzsystem berechneten Ankunftszeit vertretbar ist, um Lebensdauer zu sparen.

Bei Gefährdung der Ankunftszeit kann auch noch die Maximalleistung erhöht werden. Dies belastet sowohl Lebensdauer als auch Energieverbrauch.

### Konkretes Beispiel: Einfluss der Außentemperatur TEMP

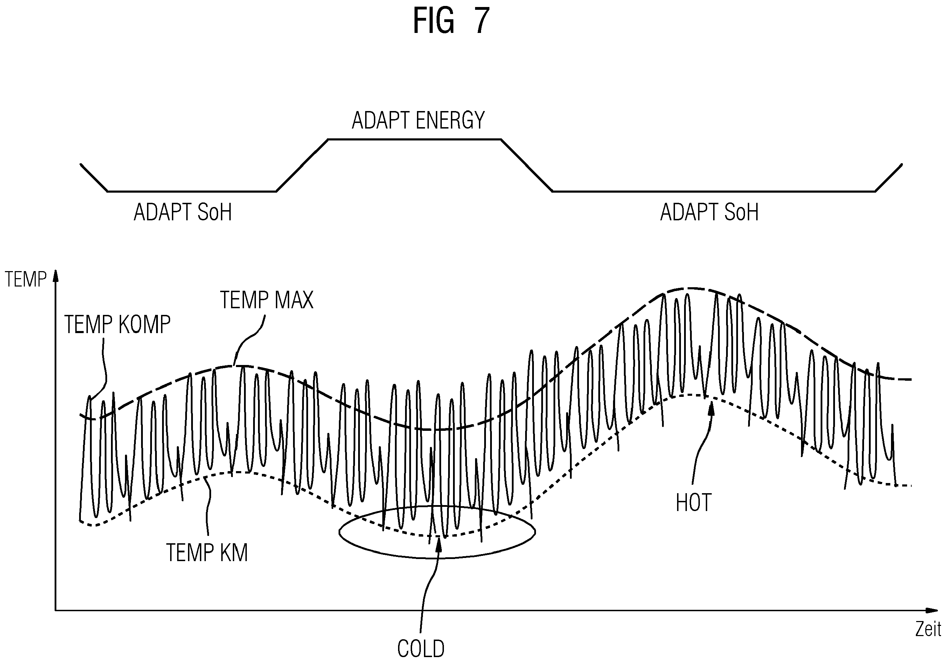

Neben der Beladung LOAD kann auch die Außentemperatur TEMP ein Kriterium zur Führung von Maßnahmen sein. Figur 7 zeigt eine solche Temperaturabhängigkeit der Steuerung. Im unteren Teil der Darstellung ist die Temperatur gegen die Zeit aufgetragen. Es ist die Temperatur TEMP KOMP der betrachteten Komponente, insbesondere eines halbleiterbasierten Bauteils, zu sehen. Deren starke Variation korrespondiert zu den vielen Temperaturhüben, welche durch die abwechselnde Be- und Entlastung der Komponente zustande kommen. Gestrichelt ist oben die Hüllkurve der maximal auftretenden Temperatur TEMP MAX gezeigt, welcher die Komponente ausgesetzt ist. Gepunktet ist unten die Temperatur TEMP KM des Kühlmittels gezeigt.

Aufgrund der Außentemperatur TEMP unterliegen die verschiedenen Temperaturen zeitlichen Schwankungen, d.h. es gibt kältere Zeitabschnitte COLD und wärmere Zeitabschnitte HOT. Die kälteren Zeitabschnitte COLD können durch Nacht oder Winter zustande kommen, die wärmeren Zeitabschnitte HOT durch Mittagshitze bzw. Sommer.

Die Steuerung kann sich diese Schwankungen der Außentemperatur zunutze machen, wie im oberen Teil der Figur 7 dargestellt ist: bei niedrigeren Temperaturen ist der Lebensdauerverbrauch der Komponente grundsätzlich niedriger, so dass Maßnahmen ADAPT ENERGY durchgeführt werden können, welche die Energieeffizienz erhöhen. Umgekehrt sollte bei heißen Außentemperaturen besonders stark Lebensdauer eingespart werden, also Maßnahmen ADAPT SoH durchgeführt werden zur Reduktion der Komponentenauslastung zu Lasten des Energieverbrauches. Hier ist auch der Einsatz von erhöhter Kühlleistung ein Mittel, um Komponentenlebensdauer einzusparen, bei gleichzeitiger Steigerung des Energieverbrauchs. Denn bei hohen Außentemperaturen wirkt sich die Kühlung viel stärker aus als im Winter oder bei Nacht.

Konkretes Beispiel: dynamische Energieeffizienzsteigerung des Antriebes bei Bedarf auf nicht-elektrifizierten Streckenabschnitten

Wenn auf Strecken mit reinem Batteriebetrieb durch unplanmäßige Ereignisse, z.B. ungeplante Stillstandszeiten oder unerwartet viele Fahrgäste, spontan der Ladezustand der Batterie knapp wird, kann die Umschaltung auf eine Energie sparende und Komponentenlebensdauer belastende Betriebsweise erfolgen. In solchen Situationen ist der SoH der Komponenten wenig wichtig, vorrangig soll die nächste Haltestelle erreicht werden.

In diesem Fall kann zusätzlich zu den die Lebensdauer verlängernden Maßnahmen auch noch die Beschleunigungsleistung eingeschränkt werden, da dies auf Kosten der Fahrzeit den Energieverbrauch reduziert.

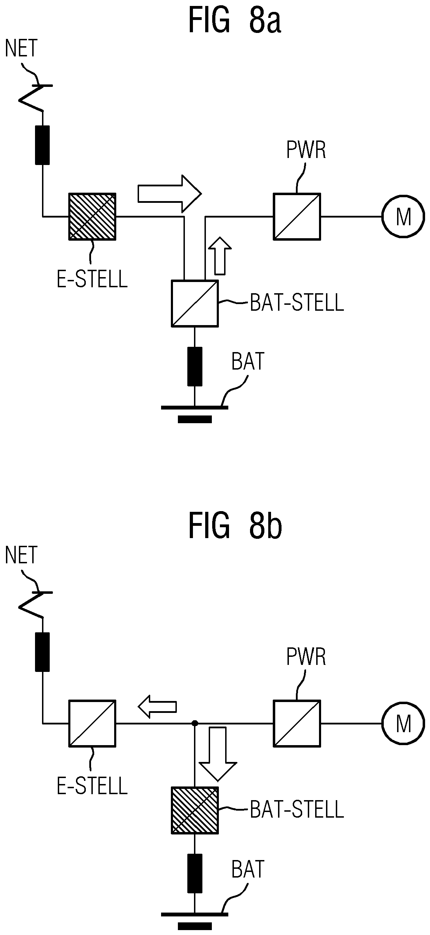

Es ist auch möglich, Lebenszeit zwischen verschiedenen Komponenten auszutauschen. Hierzu zeigt Figur 8 einen Ausschnitt aus einem Traktionssystems eines Fahrzeugs, welcher den Anschluss an ein externes Stromversorgungssystem NET, den Trafo Eingangssteller E-STELL, die Batterie BAT, den Batterie Chopper BAT-STELL, den Motorumrichter PWR, sowie den Motor M umfasst.

Figur 8a zeigt den Fall, dass die verbleibende Lebensdauer des Trafo Eingangsstellers E-STELL gering ist. In diesem Fall kann auch bei Befahren eines elektrifizierten Streckenabschnitts, wo also zum Antrieb des Fahrzeugs die Batterie BAT nicht zum Einsatz kommen müsste, die Batterie BAT zusätzlich zur externen Energieversorgung verwendet werden. So kann die Batterie BAT den Trafo Eingangssteller E-STELL zumindest bei Spitzen entlasten. Es findet also eine Umverteilung zwischen den zwei Energiequellen der Netzeinspeisung und des internen Energiespeichers statt. Bei der Entscheidung hierüber hat die Steuerung jedoch zu beachten, dass dies zu einer an sich unnötigen Batterieentladung führt. Es steht somit daher für die weitere Fahrt weniger Energie für das Fahren auf einem nicht elektrifizierten Streckenabschnitt zur Verfügung.

Figur 8b zeigt den Fall, dass die verbleibende Lebensdauer des Batterie Choppers BAT-STELL gering ist. Beim elektrischen Bremsen wird üblicherweise die Batterie BAT im Rahmen der Energierekuperation genutzt, um Energie aufzunehmen, wodurch der Batterie Chopper BAT-STELL belastet wird. Zu dessen Schonung kann ein Teil der beim Bremsen zur Verfügung gestellten Energie in das externe Stromversorgungssystem NET eingespeist werden. Wiederum ist jedoch zu beachten, dass durch diese Maßnahme die Batterie BAT weniger aufgeladen wird, so dass für das weitere Fahren weniger Energie aus der Batterie BAT entnommen werden kann.

Das Beispiel der Figur 8 zeigt also ein Balancieren zwischen dem SoH zweier Komponenten. Hierdurch erfolgt ein Eingriff in das sonst üblicherweise angewandte Lademanagement. Dies hat den Zweck, Spitzenströme, die stark auf die Lebensdauer wirken, umzuverteilen.

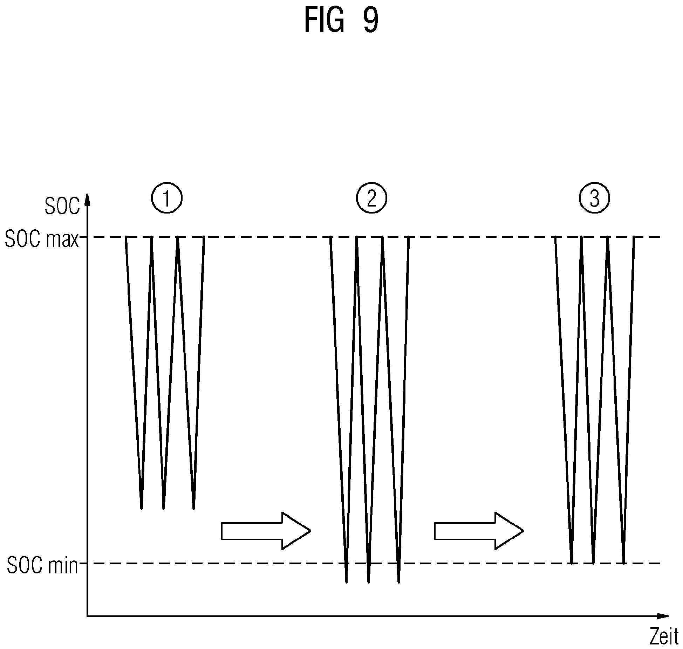

Im Folgenden wird eine weitere Möglichkeit beschrieben, Lebenszeit zwischen verschiedenen Komponenten auszutauschen. Während anhand von Figur 8 die Verlängerung der Lebensdauer von Trafo Eingangssteller oder Batterie Chopper auf Kosten der jeweils anderen Komponente erläutert wurde, wird nun diejenigen der Batterie adressiert. Hierzu zeigt Figur 9 die Änderung des Ladezustands SOC der Batterie mit der Zeit. Der erste Zustand ① entspricht einer neuen Batterie. Die nach unten verlaufenden Zacken stehen für Fahrten, die mit einer vollen Batterie, d.h. einer Batterie mit dem Ladezustand SOC max, starten, dann zu einer Entladung der Batterie führen, und mit einer erneuten Aufladung enden. Eine Alterung der Batterie, d.h. ein verschlechterter SoH, führt zu dem Zustand ②. Bei Batterien wird im Alter der Wirkungsgrad schlechter, d.h. der Innenwiderstand und die Verluste nehmen zu und die Kapazität nimmt ab. Der minimale Ladezustand der Batterie ist SOC min. Es ist anhand der Fahrtzyklen bei Zustand ②, welche den gleichen Strecken wie bei Zustand ① entsprechen, erkennbar, dass dieser minimale Ladezustand SOC min unterschritten werden müsste, d.h. die Fahrten letztlich nicht durchführbar sind.

Wenn die maximal mögliche Tiefe der Entladung nicht mehr ausreicht, um den Anforderungen an die Batterie zu genügen, kann eine Energieeffizienzsteigerung des Antriebs helfen, die Entladetiefe geringfügig zu verringern. Dies ist bei Zustand ③ gezeigt. Es werden Maßnahmen getroffen, welche ermöglichen, die Fahrten mit weniger Energieeinsatz durchzuführen. Dies bedeutet, dass die Batterie weniger Energie zur Verfügung stellen muss, wodurch die Entladung bis zum minimalen Ladezustand SOC min ausreicht.

Wie oben erläutert, erfolgt diese Steigerung der Energieeffizienz auf Kosten des SoH anderer Komponenten. Bei der beschriebenen Kompensation der Batteriealterung durch Erhöhung der Energieeffizienz wird also die Lebensdauer von Komponenten bewusst verringert, um die Batterielebensdauer hinauszuzögern, also Lebensdauer zwischen der Batterie und anderen Komponenten ausgetauscht. Auf diese Weise kann ermöglicht werden, Strecken mit reinem Batteriebetrieb überhaupt noch zu bewältigen. Dies kann insbesondere dann sinnvoll sein, wenn bestimmte Strecken eine von anderen Streckenzyklen abweichend tiefere Entladung erfordern, wie z.B. längere oberleitungsfreie Strecken.

Außer der beschriebenen Möglichkeit, trotz gealterter Batterie bestimmte nicht-elektrifizierte Strecken dennoch befahren zu können, kann die beschriebene Vorgehensweise auch den weiteren Lebensdauerverbrauch der Batterie reduzieren. Denn dadurch, dass verhindert wird, dass der Ladezustand kritische Bereiche extrem niedriger Batterieladung einnimmt, wird eine schnelle Alterung der Batterie verhindert.

Die beschriebene Steuerung wird mittels eines Computerprogramms realisiert. Dieses kann z.B. Bestandteil eines Fahrerassistenzsystems sein. Da verschiedene Maßnahmen bei unterschiedlichen Randbedingungen unterschiedlich stark auf Lebensdauer und Energieeffizienz wirken, kann dieses Computerprogramm berechnen, welche Maßnahmen bei welchen Arbeitspunkten am effizientesten in Bezug auf deren Wirkung sind und bestimmen, welche Maßnahmen durchgeführt werden sollten. Nach dieser Bestimmung, welche Maßnahmen durchgeführt werden sollten, kann das Computerprogramm dem Zugführer eine entsprechende Handlungsempfehlung geben. Das Computerprogramm berücksichtigt bei der Entscheidung über die Maßnahmen insbesondere die durch das Fahrerassistenzsystem berechnete Fahrzeit. Hierdurch kann eine dynamisch wechselnde Priorisierung zwischen Energieverbrauch, Lebensdauerverbrauch und Fahrzeit vorgenommen werden.

Die Erfindung wurde voranstehend an einem Ausführungsbeispiel beschrieben. Es versteht sich, dass zahlreiche Änderungen und Modifikationen möglich sind, ohne dass der Rahmen der Erfindung verlassen wird.

## Patentansprüche

1. Verfahren zum Betreiben eines Fahrzeugs (10), bei dem Informationen über den Gesundheitszustand (Ist-SoH) einer Komponente des Fahrzeugs (10) vorliegen,
dieser Gesundheitszustand (Ist-SoH) mit einem vorgegebenen Gesundheitszustand (Soll-SoH) verglichen wird, abhängig vom Ergebnis des Vergleichs zumindest eine den Energieverbrauch beim Betreiben des Fahrzeugs (10) erhöhende oder verringernde Maßnahme vorgenommen wird.

2. Verfahren nach Anspruch 1, wobei
der Vergleich des Gesundheitszustands (Ist-SoH) mit dem vorgegebenen Gesundheitszustand (Soll-SoH) erfolgt, indem
aus dem Gesundheitszustand (Ist-SoH) eine erwartete Lebensdauer (END Ist-SoH) ermittelt wird, und mit einer vorgegebenen Lebensdauer (END Soll-SoH) verglichen wird.

3. Verfahren nach Anspruch 2, bei dem
im Fall, dass die erwartete Lebensdauer länger als die vorgegebene Lebensdauer ist, zumindest eine den Energieverbrauch beim Betreiben des Fahrzeugs (10) verringernde Maßnahme vorgenommen wird,
und/oder
im Fall, dass die erwartete Lebensdauer kürzer als die vorgegebene Lebensdauer ist, zumindest eine den Energieverbrauch beim Betreiben des Fahrzeugs (10) erhöhende Maßnahme vorgenommen wird.

4. Verfahren nach einem der Ansprüche 1 bis 3, bei dem die mindestens eine den Energieverbrauch beim Betreiben des Fahrzeugs (10) erhöhende Maßnahme umfasst:
- eine Erhöhung der Kühlerleistung zur Kühlung der Komponente, und/oder
- eine Verringerung der anfänglichen Zugkraft beim Beschleunigen des Fahrzeugs (10), und/oder
- eine Verringerung der Pulsfrequenz der Komponente, und/oder
- eine Verringerung der Bremsleistung beim elektrischen Bremsen.

5. Verfahren nach einem der Ansprüche 1 bis 4, bei dem die Vornahme der Maßnahme ferner abhängt von dem bei Vornahme der Maßnahme bewirkten Ausmaß der Erhöhung oder Verringerung des Energieverbrauchs.

6. Verfahren nach einem der Ansprüche 1 bis 5, wobei es sich bei der Komponente um einen internen Energiespeicher (12) des Fahrzeugs (10), oder um einen Motorumrichter, oder um einen Batterie Chopper, oder um einen Trafo Eingangssteller, oder um eine Chopper Drossel, oder um einen Motor, oder um einen Hilfsbetrieb handelt.

7. Verfahren nach einem der Ansprüche 1 bis 6, bei dem die Vornahme der den Energieverbrauch erhöhenden oder verringernden Maßnahme ferner abhängt von
- der Beladung des Fahrzeugs (10), und/oder
- einer vorgegebenen Fahrzeit, und/oder
- der Außentemperatur, und/oder
- dem Ladezustand eines internen Energiespeichers (12) des Fahrzeugs (10), und/oder
- durch die Maßnahme verursachten Kosten.

8. Verfahren nach einem der Ansprüche 1 bis 7, bei dem ein Gesundheitszustand einer zweiten Komponente mit einem zweiten vorgegebenen Gesundheitszustand verglichen wird,
abhängig zusätzlich vom Ergebnis dieses zweiten Vergleichs die zumindest eine den Energieverbrauch beim Betreiben des Fahrzeugs (10) erhöhende oder verringernde Maßnahme vorgenommen wird.

9. Vorrichtung oder System zur Datenverarbeitung, umfassend Mittel zur Ermittlung von Vorgaben, welche das Betreiben eines Fahrzeugs (10) gemäß dem Verfahren nach einem der Ansprüche 1 bis 8 ermöglichen.

10. Computerprogramm, umfassend Befehle, die bei der Ausführung des Programms veranlassen, die Schritte des Verfahrens nach einem der Ansprüche 1 bis 8 auszuführen.

11. Computerprogramm nach Anspruch 10, umfassend
eine erste Rückkopplungsschleife, welche die Auswirkung einer Maßnahme auf den Gesundheitszustand (Ist-SoH) ermittelt, und/oder
eine zweite Rückkopplungsschleife, welche die Auswirkung einer Maßnahme auf den Energieverbrauch ermittelt.

12. Computerlesbarer Datenträger, auf dem das Computerprogramm nach Anspruch 10 gespeichert ist.

13. Datenträgersignal, das das Computerprogramm nach Anspruch 10 überträgt.
